# EUROPÄISCHE PATENTANMELDUNG

(11) **EP 4 832 673 A1**
(43) Veröffentlichungstag der Anmeldung: **28.10.2026**
(21) Anmeldenummer: 25172226.0
(22) Anmeldetag: 24.04.2025
(51) Int. Cl.: H05K 1/14, H05K 3/30, H05K 3/34, H05K 1/02

(54) **VERFAHREN ZUR BESTÜCKUNG VON MINDESTENS ZWEI ELEKTRONISCHEN BAUELEMENTEN AUF EINER LEITERPLATTE**

(71) Anmelder: Siemens Aktiengesellschaft, 80333 München (DE)
(72) Erfinder: Müller, Bernd, 16259 Falkenberg (DE); Pfeifer, Markus, 90455 Nürnberg (DE); Strogies, Jörg, 14163 Berlin (DE)
(74) Vertreter: Siemens Patent Attorneys

(57) **Zusammenfassung**

Die Erfindung betrifft ein Verfahren zur Bestückung von mindestens zwei elektronischen Bauelementen (2) auf einer Leiterplatte (4), wobei die elektronischen Bauelementen (2) mindestens eine Konnektorfläche (6) zu einem Kühlkörper (8) aufweist, die in einer Einbaulage parallel zur Leitplatte (4) angeordnet ist und dabei von der Leiterplattenoberfläche (10) weg zeigt und wobei an einer Trägerplatte (12) der Bauelemente (2) Befestigungsfüße (14) angeordnet sind, wobei mittels eines Nivellierungswerkzeugs (16) die mit der Konnektorfläche (6) versehene Seite der Bauelemente (2) in der Art an die Leiterplatte (4) gedrückt wird, so dass Fußenden (18) der Befestigungsfüße (14) in Bohrungen (20) in der Leiterplatte (4) kraftschlüssig eingepresst werden, wodurch die Konnektorflächen (6, 6') der Bauelementen (2, 2') auf der Leiterplatte (4) in einer Ebene liegen.

## Beschreibung

Die Erfindung betrifft ein Verfahren zur Bestückung von mindestens zwei elektronischen Bauelementen auf einer Leiterplatte nach Patentanspruch 1.

In der Montage und in der Fertigung von Leiterplatten mit elektronischen Bauelementen, beispielsweise von Leistungselektronik-Bauelementen stellt sich immer die Herausforderung, dass mehrere elektronische Bauelemente an einen gemeinsamen Kühlkörper adressiert sind, das heißt an diesen wärmeüberleitend und wärmeübertragend angeschlossen sind. Problematisch ist dabei die Ausrichtung einer Mehrzahl von leistungselektronischer Bauelemente, welche sich typischerweise auf einer gemeinsamen Trägerplatte, also einer Motherboard-Komponente befinden. Unter Berücksichtigung der akkumulierten Maß- und Form- und Lagetoleranzen in dem Gesamtaufbau ist ein erheblicher technischer Aufwand zu betreiben, dass die elektronischen Bauelementen mit einer möglichst genauen Flächenpassung an den Kühlkörper zur Wärmeübertragung angeschlossen sind. Die Länge der Maßketten in den Aufbauten würde bei entsprechend enger Tolerierung der Einzelmaße des Aufbauprinzips zu kostenintensiven und damit unwirtschaftlichen Rahmenbedingungen führen. Um dieses Problem zu umgehen, wird typischerweise als Kompensationselement die geometrische Ausbildung der Fügezonen zwischen der Leiterplatte, also dem Motherboard, genutzt. Dabei kommen beispielsweise Pins an den elektronischen Bauelementen in der Durchsteckmontage beim Löten (mit Vollwelle oder Selektivlöten) zum Einsatz. Hierbei werden während des Lötens aufwendige Vorrichtungen zur Fixierung der entsprechenden Flächen an den elektronischen Bauelementen angeordnet. Diese müssen nach dem Lötprozess, also nach dem Fertigungsprozess, aufwendig entfernt werden. Außerdem ist dies technologisch aufwendig und kostenintensiv.

Die Aufgabe der Erfindung besteht darin, ein Verfahren zur Bestückung von mindestens zwei elektronischen Bauelementen auf einer Leiterplatte bereitzustellen, das gegenüber dem bekannten Stand der Technik technisch unaufwendiger und kostengünstiger ist.

Die Lösung der Aufgabe besteht in einem Verfahren zur Bestückung von elektronischen Bauelementen auf einer Leiterplatte mit den Merkmalen des Patentanspruchs 1. Das Verfahren zur Bestückung von mindestens zwei elektronischen Bauelementen auf einer Leiterplatte zeichnet sich dabei dadurch aus, dass mindestens zwei elektronische Bauelemente jeweils eine Konnektorfläche zu einem Kühlkörper aufweisen. Die Konnektorflächen sind in einer Einbaulage der elektronischen Bauelemente parallel zur Leiterplatte angeordnet und zeigen dabei von der Leiterplattenoberfläche weg. Der Begriff "von der Leiterplattenoberfläche weg zeigen" bedeutet dabei den Gegensatz zu einer sogenannten Face-to-Face-Anordnung. Das heißt zwischen der Konnektorfläche und der Leiterplattenoberfläche ist das elektronische Bauelement angeordnet bzw. zwischengelagert. Ferner ist eine Trägerplatte der elektronischen Bauelemente vorgesehen, an der das Bauelemente angeordnet ist bzw. von der das Bauelement getragen wird und an der Trägerplatte sind Befestigungsfüße angeordnet. Mittels eines Nivellierungswerkzeuges wird die mit der Konnektorfläche versehene Seite des Bauelements in der Art an die Leiterplatte gedrückt, dass Fußenden der Befestigungsfüße in spezielle Bohrungen der Leiterplatte kraftschlüssig eingepresst werden. Hierdurch werden die Konnektorflächen der mindestens zwei Bauelementen auf der Leiterplatte so angeordnet, dass sie in einer Ebene liegen.

Durch das kraftschlüssige Einpressen der Fußenden der Befestigungsfüße in speziell dafür vorgesehene Bohrungen der Leiterplatte wird die Trägerplatte und mit ihr das Bauelemente und im Weiteren die bezüglich des jeweiligen Bauelements fest angeordnete Konnektorfläche kraftschlüssig fixiert. Das Nivellierungswerkzeug wiederum gewährleistet beim Anpressen der Komponente (unter Komponente wird die Kombination aus Bauelement mit Konnektorfläche auf der Trägerplatte sowie die Befestigungsfüße verstanden), dass die Konnektorfläche eine definierte Höhe und eine definierte Ausrichtung bezüglich der Oberfläche der Leiterplatte aufweist. Mit demselben Nivellierungswerkzeug können somit die mindestens zwei elektronischen Bauelementen mit der Konnektorfläche eine definierte Ebene parallel zur Leiterplatte bilden, auf der definiert der Kühlkörper angeordnet werden kann. Durch diese möglichst gute Parallelität der Konnektorflächen der einzelnen Bauelementen zum Kühlkörper kann die Wärmeübertragung von den Bauelementen zum Kühlkörper verbessert werden und andererseits kann das Nivellierungswerkzeug direkt nach der Montage wieder abgenommen werden, es muss nicht während des Lötprozesses an der Leiterplatte befestigt sein.

In einer vorteilhaften Ausgestaltungsform der Erfindung sind an einer zur Leiterplatte hinzeigenden Fläche der Trägerplatte Kontaktpins angeordnet, die durch Lötbohrungen in der Leiterplatte geführt werden und mittels eines Lotes verlötet werden. Die beschriebenen Kontaktpins werden somit durch die Lötbohrungen in der Leiterplatte geführt, ohne dass eine Fixierung der Trägerplatte bzw. der Bauelemente bezüglich der Leiterplatte nötig ist, um die Lötverbindung herzustellen.

In einer weiteren Ausgestaltungsform der Erfindung ist die Trägerplatte, die auch in Form eines Zwischenverdrahtungsträger (im Englischen als Interposer bezeichnet) in einen Hilfsrahmen eingesetzt, an dem wiederum die Befestigungsfüße angeordnet sind. Der Hilfsrahmen hat hierbei mehrere vorteilhafte Bedeutungen, zum einen dient er insbesondere als Befestigungsrahmen für die Befestigungsfüße, die wiederum zur Fixierung der Trägerplatte bezüglich der Leiterplatte dient. Ferner ist es zweckmäßig, wenn am Hilfsrahmen Rastnasen vorgesehen sind, in denen die Trägerplatte eingerastet wird. Somit ist die Trägerplatte bezüglich des Hilfsrahmens und im Weiteren bezüglich der Befestigungsfüße ortsfest fixiert. Dabei ist der Hilfsrahmen bevorzugt ein Kunststoffrahmen, da auch in dieser Form die Rastnasen besonders gut wirken können und die Befestigungsfüße als Kunststoffteile in vorteilhafter Form kraftschlüssig in die Leiterplatte bzw. in die Bohrungen in der Leiterplatte eingelassen werden kann. Ist ein Hilfsrahmen vorgesehen, ist dieser auch Teil der Komponente).

In einer weiteren Ausgestaltungsform der Erfindung ist das Nivellierungswerkzeug in der Art ausgestaltet, dass eine erste Nivellierungsfläche vorgesehen ist, die während des Andrückens der Bauelemente an die Leiterplatte auf die Konnektorfläche aufgelegt wird. Eine zweite Nivellierungsfläche ist dafür vorgesehen, dass sie auf der Leiterplatte aufgelegt wird. Die zweite Nivellierungsfläche ist vorteilhafterweise wiederum so ausgestaltet, dass sie mindestens an zwei Punkten, idealerweise jedoch um einen Einbauplatz der Trägerplatte herum, mehrere, insbesondere drei Stützpunkte aufweist, sodass das Nivellierungswerkzeug unverkippbar (statisch bestimmt) mit einer definierten parallelen Auflage zur Leiterplatte ansetzbar ist.

In einer weiteren Ausgestaltungsform der Erfindung ist zwischen dem jeweiligen Bauelement und der jeweiligen Trägerplatte ein Unterfüllmaterial aufgebracht, das wiederum die jeweilige Bauelemente bezüglich der jeweiligen Trägerplatte fixiert und thermische bzw. mechanische Spannungen zwischen beiden Bauteilen reduziert. Das Unterfüllmaterial schaut wiederum in der Regel unter dem Bauelement hervor, und fließt auf der Trägerplatte nach außen. Dies wird durch den Hilfsrahmen bzw. einer erhöhten Barriere des Hilfsrahmens bezüglich der Normalen zur Leiterplatte verhindert, sodass überschüssiges Unterfüllmaterial durch die Erhöhung am Hilfsrahmen zurückgehalten wird.

Weitere Merkmale und weitere Ausgestaltungsformen der Erfindung sind anhand der folgenden Figuren näher erläutert. Merkmale mit derselben Bezeichnung, aber in unterschiedlichen Ausgestaltungsformen, sind dabei mit denselben Bezugszeichen versehen. Es handelt sich dabei um rein schematische und beispielhafte Ausgestaltungsformen, die keine Einschränkung des Schutzbereichs darstellen.

Dabei zeigen:
- Figur 1: einen Querschnitt durch die Montage einer Komponente mit einer Trägerplatte und einem Bauelemente auf einer Leiterplatte mittels eines Nivellierungswerkzeugs,
- Figur 2: die auf der Leiterplatte fixierte Komponente während des Lötprozesses,
- Figur 3: die Unterseite einer Komponente, die zur Leiterplatte hin gerichtet ist und
- Figur 4: einen Querschnitt durch eine Leiterplatte mit mehreren Komponenten und einem darauf nivelliert angeordneten Kühlkörper.

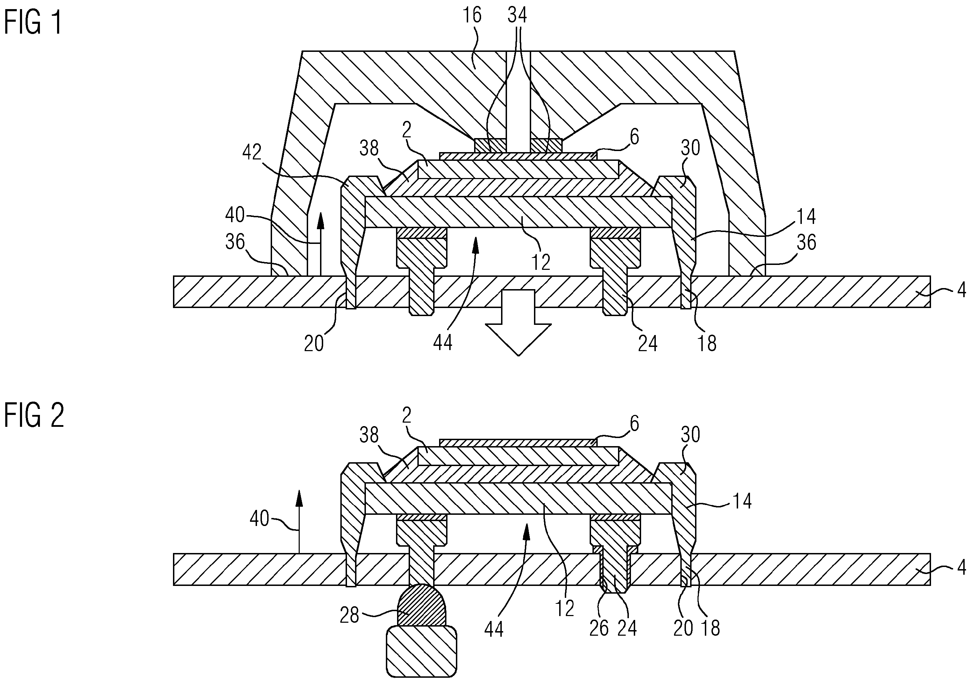

In Figur 1 ist der Querschnitt einer elektronischen Komponente 44 (insbesondere eine Leistungselektronik-Komponente), die im Weiteren definiert wird als die Kombination von einer Trägerplatte 12, auf der ein elektronisches Bauelement 2 befestigt ist und ein Unterfüllmaterial 38 zwischen diesen beiden angeordnet ist, wobei auf dem Bauelement 2 eine Konnektorfläche 6 angeordnet ist. Ferner gehört zur Komponente ein Hilfsrahmen 30, in dem die Trägerplatte 12 eingepasst und fixiert ist, wobei der Hilfsrahmen 30 Befestigungsfüße 14 aufweist.

Diese Komponente 44 wird so auf die Leiterplatte 4 aufgesetzt, dass Fußenden 18 durch Bohrungen 20 in der Leiterplatte 4 gesteckt werden. Die Leiterplatte 4 wird im Allgemeinen auch als Motherboard bezeichnet und unterscheidet sich von der Trägerplatte 12, die die elektronische Bauelemente 2 umfasst, darin, dass diese Trägerplatte 12 ein Unterverdrahtungsträger-Substrat ist, was im Englischen auch als Interposer bezeichnet wird. An dieser Trägerplatte 12, also dem Interposer 12, sind des Weiteren Kontaktpins 24 angeordnet, die in Richtung einer Leiterplattenoberfläche 10 zeigen und durch Lötbohrungen 26 in der Leiterplatte 4 geführt sind. Dabei besteht zwischen den Kontaktpins 24 und den Rändern der Lötbohrung 26 jeweils ein Spiel, durch das Lotmaterial in flüssiger Form mittels Kapillarkräfte eingesaugt werden kann, wodurch nach dem Lötprozess (vergleiche Figur 2) eine feste Lötverbindung entsteht.

Im Gegensatz zu den Kontaktpins 24, die in der Bohrung 26 mit einem Spiel versehen sind, werden die Fußenden 18 in die Bohrungen 20 der Leiterplatte 4 kraftschlüssig eingepresst, sodass sie bezüglich der Leiterplatte fixiert sind.

Die Komponente 44 wird dabei in die beschriebenen Bohrungen 20 und 26 eingedrückt, wobei hierfür ein Nivellierungswerkzeug 16 verwendet wird. Das Nivellierungswerkzeug 16 weist dabei zwei verschiedene Nivellierungsflächen 34 und 36 auf. Die Nivellierungsfläche 34 ist so ausgestaltet, dass sie auf der Konnektorfläche 6 eben aufliegt. Dabei ist zur Konnektorfläche 6 zu sagen, dass es sich hierbei z. B. um eine metallische Beschichtung auf dem elektronischen Bauelement 2 handeln kann, es kann jedoch auch eine Folie bzw. eine Platte auf die Oberfläche des Bauelements 2 aufgeklebt oder aufgelötet sein. Dabei ist es von Bedeutung, dass die Konnektorfläche 6 eine hohe thermische Leitfähigkeit, insbesondere mehr als 20 W/mK bevorzugt mehr als 150 W/mK aufweist.

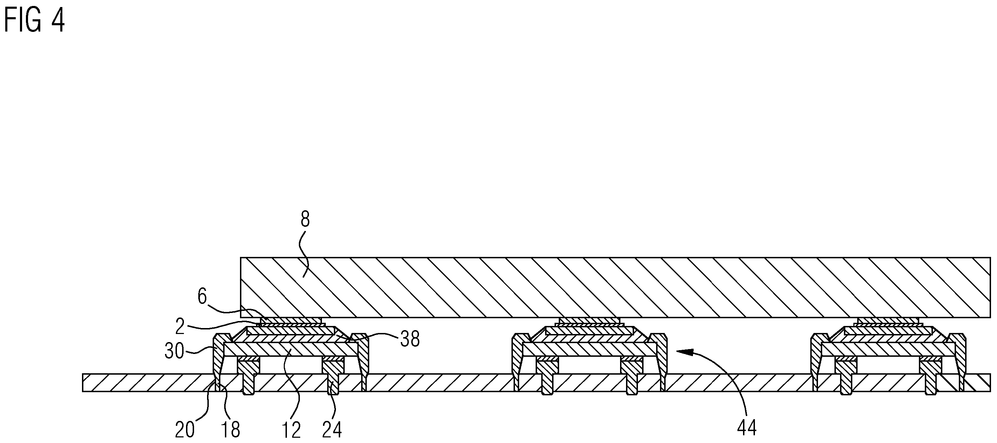

Die zweite Nivellierungsfläche 36 des Nivellierungswerkzeugs 16 liegt dabei auf der Leiterplatte 4 auf, wie das in Figur 1 dargestellt ist. Durch das beschriebene Nivellierungswerkzeug 16 wird sichergestellt, dass die Komponente 44 mit den Fußenden 18 so in die Bohrungen 20 passgenau eingepresst werden, dass die Konnektorfläche 6 parallel zur Leiterplattenoberfläche 10 ausgerichtet ist. Das Nivellierungswerkzeug 16 kann nach dem Einsetzen der Komponente 44 abgenommen werden, bevor die Leiterplatte 4 mit mehreren Komponenten 44 (vergleiche Figur 4) dem Lötprozess, wie dies in Figur 2 beschrieben ist, zugeführt wird.

Ein Vorteil in der beschriebenen Vorgehensweise bezüglich Figur 1 und Figur 2 besteht darin, dass das Nivellierungswerkzeug während des Lötvorganges nicht mit durch den Lötprozess geführt werden muss, sondern dass es vorher abgenommen wird. Der zweite Vorteil besteht darin, dass, wie in Figur 4 zu erkennen ist, eine Mehrzahl, mindestens zwei Komponenten mit elektronischen Bauelementen 2 und Konnektorflächen 6 so nivelliert auf der Leiterplatte ausgerichtet ist, dass die Konnektorflächen 6 möglichst genau in einer Ebene liegen, was das Aufbringen und das thermische Kontaktieren mit einem Kühlkörper 8 erleichtert. Die einzelnen Konnektorflächen 6 liegen so an dem Kühlkörper 8 an, dass eine möglichst gute und flächige Wärmeübertragung zwischen Konnektorflächen 6 und dem Kühlkörper 8 möglich ist. Hier gibt es keine wesentlichen Verkantungen, die die Wärmeübertragung zwischen der Konnektorfläche 6 und dem Kühlkörper 8 reduzieren könnte.

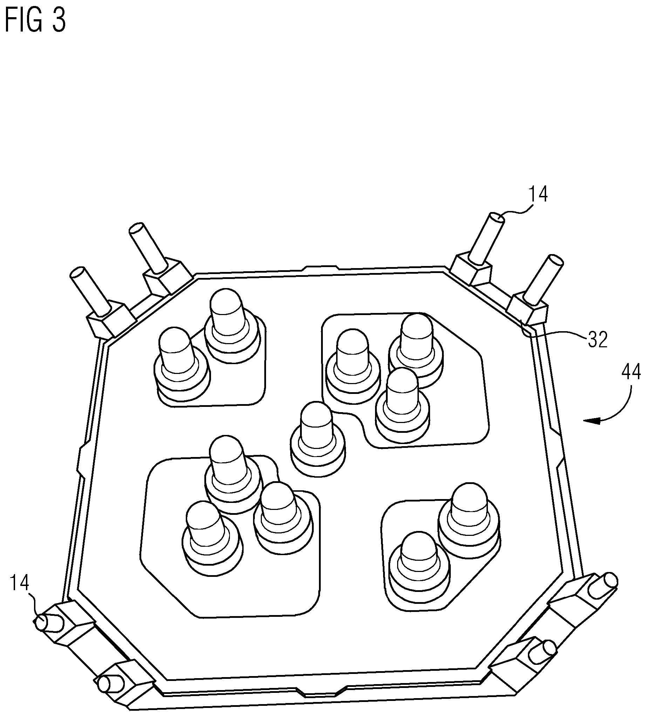

In Figur 3 ist noch ein Blick auf eine Unterseite der Komponente 44 gegeben, insbesondere auf eine Unterseite der Trägerplatte 12, an der die Kontaktpins 24 herausragen. Es ist zu erkennen, dass die Trägerplatte 12 in den Hilfsrahmen 30 mittels Rastnasen 32 eingerastet ist. Diese Rastnasen 32 halten die Trägerplatte 12 wiederum ortsfest bezüglich des Hilfsrahmens 30 und dessen Befestigungsfüße 14.

### Bezugszeichenliste

- 2: elektronischer Komponent
- 4: Leiterplatte
- 6: Konnektorfläche
- 8: Kühlkörper
- 10: Leiterplattenoberfläche
- 12: Trägerplatte
- 14: Befestigungsfüße
- 16: Nivellierungswerkzeug
- 18: Fußenden
- 20: Bohrungen
- 22: Fläche
- 24: Kontaktpins
- 26: Lötbohrungen
- 28: Lot
- 30: Hilfsrahmen
- 32: Rustnasen
- 34: erste Nivellierungsfläche
- 36: zweite Nivellierungsfläche
- 38: Unterfüllmaterial
- 40: Normale
- 42: Rand Hilfsrahmen
- 44: Komponente

## Patentansprüche

1. Verfahren zur Bestückung von mindestens zwei elektronischen Bauelementen (2) auf einer Leiterplatte (4), wobei die elektronischen Bauelemente (2) mindestens eine Konnektorfläche (6) zu einem Kühlkörper (8) aufweist, die in einer Einbaulage parallel zur Leitplatte (4) angeordnet ist und dabei von der Leiterplattenoberfläche (10) weg zeigt und wobei an einer Trägerplatte (12) der Bauelementen (2) Befestigungsfüße (14) angeordnet sind, wobei mittels eines Nivellierungswerkzeugs (16) die mit der Konnektorfläche (6) versehene Seite der Bauelemente (2) in der Art an die Leiterplatte (4) gedrückt wird, so dass Fußenden (18) der Befestigungsfüße (14) in Bohrungen (20) in der Leiterplatte (4) kraftschlüssig eingepresst werden, wodurch die Konnektorflächen (6, 6') der Bauelementen (2, 2') auf der Leiterplatte (4) in einer Ebene liegen.

2. Verfahren nach Anspruch 1, **dadurch gekennzeichnet, dass** an einer zur Leiterplatte (4) hinzeigenden Fläche (22) der Trägerplatte (12) Kontaktpins (24) angeordnet sind, die durch LötBohrungen (26) in der Leiterplatte (4) geführt werden und mittels eines Lotes (28) verlötet werden.

3. Verfahren nach Anspruch 1 oder 2, **dadurch gekennzeichnet, dass** die Trägerplatte in einen Hilfsrahmen (30) eingesetzt wird, an dem die Befestigungsfüße (14) angeordnet sind.

4. Verfahren nach Anspruch 3, **dadurch gekennzeichnet, dass** in dem Hilfsrahmen Rastnasen (32) vorgesehen sind, in dem die Trägerplatte (12) eingerastet wird.

5. Verfahren nach einem der Ansprüche 3 oder 4, **dadurch gekennzeichnet, dass** der Hilfsrahmen (30) ein Kunststoffrahmen ist.

6. Verfahren nach einem der vorhergehenden Ansprüche, **dadurch gekennzeichnet, dass** das Nivellierungswerkzeug (16) eine erste Nivellierungsfläche (34) aufweist, die während des Andrückens der Bauelemente (2) an die Leiterplatte (4) auf der Konnektorfläche (6) aufgelegt wird und eine zweite Nivellierungsfläche (36) aufweist, die auf der Leiterplatte (4) aufgelegt wird.

7. Verfahren nach einem der vorhergehenden Ansprüche, **dadurch gekennzeichnet, dass** zwischen die Bauelemente (2) und die Trägerplatte (12) ein Unterfüllmaterial (38) gebracht wird.

8. Verfahren nach Anspruch 7, **dadurch gekennzeichnet, dass** der Hilfsrahmen bezüglich einer Normalen (40) zur Leiterplatte (4) gegenüber der Trägerplatte (12) erhöht ist und somit eine Barriere für des Unterfüllmaterial (38) darstellt.

9. Verfahren nach einem der vorhergehenden Ansprüche, **dadurch gekennzeichnet, dass** die Trägerplatte (12) für die Bauelemente (2) ein Umverdrahtungsträger-Substrat ist.
